(19) **Europäisches Patentamt / European Patent Office / Office européen des brevets**

(11) **EP 2 784 529 B1**

(12) # FASCICULE DE BREVET EUROPEEN

(45) Date de publication et mention de la délivrance du brevet:
**16.03.2016 Bulletin 2016/11**

(51) Int Cl.:
***G01R 33/00*** *(2006.01)*

(21) Numéro de dépôt: **14161189.7**

(22) Date de dépôt: **21.03.2014**

(54) **Système de détermination d'au moins un paramètre de déplacement d'un organe mobile par rapport à une structure fixe**

System zur Bestimmung mindestens eines Bewegungsparameters eines mobilen Organs in Bezug auf eine feststehende Struktur

System for determining at least one movement parameter of a member that is movable relative to a stationary structure

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.03.2013 FR 1352937**

(43) Date de publication de la demande:
**01.10.2014 Bulletin 2014/40**

(73) Titulaire: **NTN-SNR Roulements
74000 Annecy (FR)**

(72) Inventeurs:
- **Duret, Christophe
  74290 Bluffy (FR)**
- **Vandamme, Etienne
  74650 Chavanod (FR)**

(74) Mandataire: **Sayettat, Julien Christian
STRATO-IP
18, rue Soleillet
75020 Paris (FR)**

(56) Documents cités:
**US-A1- 2010 231 213      US-A1- 2012 158 349
US-A1- 2012 176 070**

**Description**

L'invention concerne un système de détermination d'au moins un paramètre de déplacement d'un organe mobile par rapport à une structure fixe.

Dans de nombreuses applications, on souhaite connaître en temps réel et avec une qualité optimale au moins un paramètre de déplacement linéaire et/ou angulaire d'un organe mobile, tel que sa position, sa vitesse, son accélération ou son sens de déplacement.

Pour ce faire, le document WO-2006/064169 propose l'utilisation d'un codeur destiné à être solidaire de l'organe mobile et qui est agencé pour émettre un champ magnétique pseudo sinusoïdal à distance de lecture d'un capteur comprenant plusieurs éléments sensibles.

De façon avantageuse, chaque élément sensible peut comprendre au moins un motif à base d'un matériau magnétorésistif à effet tunnel (TMR en anglais pour Tunnel MagnetoResistance) dont la résistance varie en fonction dudit champ magnétique, tel que par exemple décrit dans le document WO-2004/083881.

En particulier, chaque motif comprend alors deux couches conductrices entre lesquelles une couche isolante est disposée pour former une succession de jonctions tunnel dans un montage de détection. Les couches conductrices forment respectivement une couche magnétique sensible au champ à mesurer et une couche magnétique de référence, la résistance électrique entre les couches conductrices étant fonction de l'orientation relative de l'aimantation de chacune desdites couches.

Pour déterminer un paramètre de déplacement de l'organe mobile en fonction de l'évolution du champ magnétique détecté, le document WO-2006/064169 prévoit une combinaison des signaux représentatifs de la résistance de chacun des éléments sensibles afin de délivrer deux signaux en quadrature et de même amplitude qui peuvent être utilisés pour calculer ledit paramètre.

Dans certaines applications, on souhaite également connaître la température de fonctionnement de l'ensemble mécanique dans lequel l'organe est mobile, notamment en tant qu'indicateur de son état de santé et/ou de ses conditions de fonctionnement.

Pour ce faire, il est connu d'utiliser une sonde de température qui est intégrée au voisinage de l'organe mobile. Toutefois, cette sonde a un coût, est encombrante et ne permet pas de mesurer la température au plus près de l'organe mobile.

Par ailleurs, le document US-2010/0231213 prévoit de mesurer la température au moyen d'un capteur magnétorésistif, et le document US-2012/0158349 décrit un procédé de mesure de l'augmentation de température induite par un courant et/ou une tension de polarisation dans une jonction tunnel magnétique.

L'invention vise à résoudre les problèmes de l'art antérieur en perfectionnant un système de détermination d'au moins un paramètre de déplacement d'un organe mobile permettant de déterminer également une température de fonctionnement.

A cet effet, l'invention propose un système de détermination d'au moins un paramètre de déplacement d'un organe mobile par rapport à une structure fixe, ledit système comprenant :

- un codeur destiné à être solidaire de l'organe mobile de sorte à se déplacer conjointement avec lui, ledit codeur étant agencé pour émettre un champ magnétique périodique qui est représentatif du déplacement du codeur ;
- un capteur de détection d'un champ magnétique périodique comprenant plusieurs éléments sensibles qui sont intégrés dans un montage, ledit capteur étant destiné à être solidaire de la structure fixe avec les éléments sensibles à distance de détection du champ magnétique périodique émis par le codeur, chaque élément sensible comprenant au moins un motif à base d'un matériau magnétorésistif à effet tunnel dont la résistance varie en fonction dudit champ magnétique, ledit capteur comprenant un dispositif de conditionnement de signaux représentatifs de la résistance des éléments sensibles qui est agencé pour délivrer au moins un signal représentatif dudit champ magnétique, ledit capteur comprenant en outre un dispositif de traitement d'un signal représentatif de la résistance totale du montage, ledit dispositif étant agencé pour délivrer un signal représentatif de la température dudit montage qui est sensiblement indépendant du champ magnétique à détecter ;
- un dispositif de calcul pour déterminer le paramètre de déplacement de l'organe mobile en fonction du signal délivré par le dispositif de conditionnement ;
- un dispositif de détermination d'une température de fonctionnement dudit système en fonction du signal délivré par le dispositif de traitement.

D'autres particularités et avantages de l'invention apparaîtront dans la description qui suit, faite en référence aux figures jointes, dans lesquelles :

- la figure 1 est une représentation fonctionnelle d'un capteur selon un premier mode de réalisation de l'invention, la figure 1a représentant le montage en pont de Wheatstone dudit capteur ;

- la figure 2 est une représentation fonctionnelle d'un capteur selon un deuxième mode de réalisation de l'invention, la figure 2a représentant le montage en boucle de courant dudit capteur ;

En relation avec ces figures, on décrit un système de détermination d'au moins un paramètre de déplacement d'un organe mobile par rapport à une structure fixe. En particulier, le paramètre peut être choisi parmi un paramètre de déplacement linéaire et/ou angulaire de l'organe mobile, tel que sa position, sa vitesse, son accélération ou son sens de déplacement.

Dans une application particulière, le système peut être utilisé en relation avec un palier à roulement pour mesurer un paramètre de rotation de l'organe tournant dudit palier par rapport à son organe fixe. En particulier, le palier peut permettre le montage d'une roue de véhicule automobile, le paramètre déterminé pouvant être utilisé dans un système de contrôle dynamique du véhicule comme par exemple l'ABS ou l'ESP.

Le système de détermination comprend un codeur destiné à être solidaire de l'organe mobile de sorte à se déplacer conjointement avec lui, ledit codeur étant agencé pour émettre un champ magnétique périodique qui est représentatif du déplacement du codeur et donc de l'organe mobile.

Selon une réalisation particulière, le codeur comprend une succession alternée de pôles magnétiques Nord et Sud qui sont disposés pour délivrer un signal magnétique pseudo sinusoïdal dont la période spatiale est égale à $\lambda = 2.$ Lp, Lp étant la longueur de chaque pôle.

Le système de détermination comprend également un capteur qui est destiné à être solidaire de la structure fixe, ledit capteur étant destiné à détecter le champ magnétique périodique délivré par le codeur. Pour ce faire, le capteur comprend plusieurs éléments sensibles 1 qui sont disposés à distance de détection du champ magnétique.

Chaque élément sensible 1 comprend au moins un motif à base d'un matériau magnétorésistif à effet tunnel dont la résistance varie en fonction du champ magnétique. De façon générale, la résistance R aux bornes de chacun des éléments sensibles 1 peut s'écrire : $R = R_0 + \Delta R.\sin(\omega t)$, $R_0$ étant la résistance de base dudit élément et $\omega$ la pulsation du champ magnétique délivré par le codeur en fonction du temps t.

De façon avantageuse, un élément sensible 1 peut comprendre un seul motif ou un groupe de motifs reliés en série. En particulier, comme décrit dans le document WO-2004/083881, chaque motif forme une jonction tunnel en comprenant un empilement d'une couche magnétique de référence, d'une couche de séparation et d'une couche magnétique sensible au champ à détecter, la résistance entre les couches magnétiques étant fonction de l'orientation relative de leur aimantation.

Le capteur comprend un dispositif de conditionnement de signaux représentatifs de la résistance des éléments sensibles 1 qui est agencé pour délivrer au moins un signal S représentatif du champ magnétique. En particulier, le dispositif de conditionnement peut comprendre des moyens de mesure de signaux qui sont chacun représentatifs de la résistance d'un élément sensible 1, ainsi que des moyens de combinaison desdits signaux pour délivrer au moins un signal S représentatif du champ magnétique.

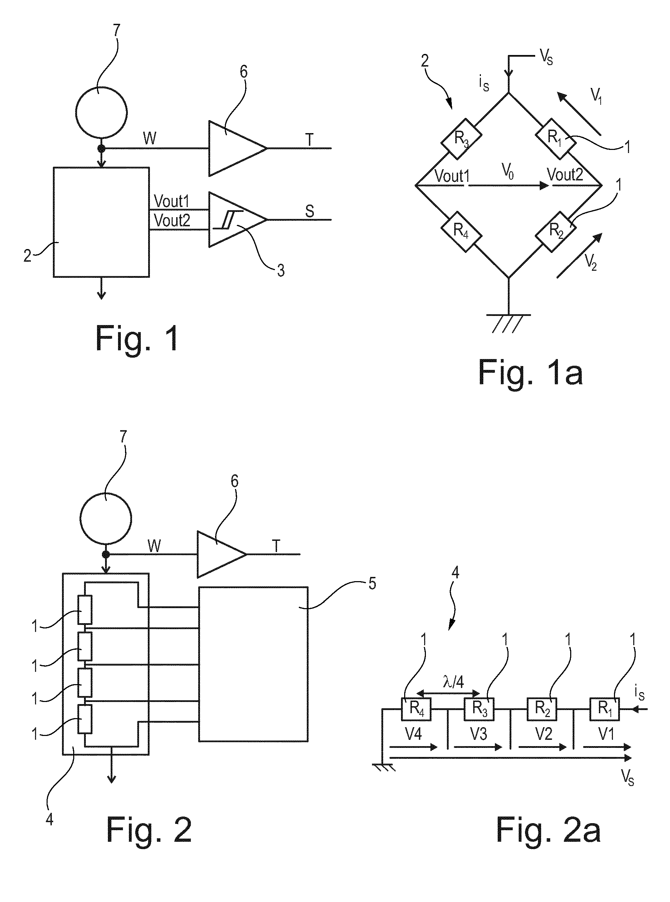

En relation avec les figures 1, on décrit ci-dessous l'intégration des éléments sensibles 1 dans un montage 2 en pont de Wheatstone qui est associé à un dispositif de conditionnement comprenant un comparateur 3 des sorties $V_{out1}$, $V_{out2}$ dudit pont.

Dans la configuration du pont de Wheatstone représentée sur la figure 1a, la sortie $V_0$ est donnée par la formule générale :

$$Vo = \left( \frac{R_2}{R_1 + R_2} - \frac{R_4}{R_3 + R_4} \right).Vs$$

Les résistances $R_1$-$R_4$ de chacune des branches du pont de Wheatstone peuvent correspondre à la résistance d'un élément sensible 1 pour former un montage de mesure en pont complet. En variante, on peut utiliser une configuration en demi pont - respectivement en quart de pont - dans laquelle seulement deux branches - respectivement une branche - intègrent chacune un élément sensible 1, les autres résistances étant égales à $R_0$.

Dans le cas d'une configuration en demi pont avec $R_3 = R_4 = R_0$, la sortie $V_0$ s'écrit :

$$Vo = \left( \frac{R_2}{R_1 + R_2} - \frac{1}{2} \right).Vs$$

$$= \frac{R_1 - R_2}{2(R_1 + R_2)}.Vs$$

Lorsque les deux éléments sensibles 1 sont intégrés dans respectivement une branche du pont de Wheatstone avec leurs barycentres espacés d'une distance $\lambda/2$, les résistances s'écrivent alors :

$$R_1 = R_0 + \Delta R.\sin (\omega t)$$

$$R_2 = R_0 + \Delta R.\sin (\omega t+\pi) = R_0 - \Delta R.\sin (\omega t)$$

Et, la sortie $V_0$ devient proportionnelle à l'amplitude du champ magnétique avec la formule :

$$Vo = \frac{\Delta R.\sin(\omega t)}{2R_0}.Vs$$

Ainsi, un dispositif de calcul du système peut permettre de déterminer le paramètre de déplacement de l'organe mobile en fonction du signal S délivré par le dispositif de conditionnement, ledit paramètre étant déterminé de façon indépendante de la température. En particulier, une bascule de Schmitt 3 peut être utilisée pour reconstruire à partir des signaux de sortie $V_{out1}$, $V_{out2}$ du pont un signal S tout ou rien à la fréquence du champ magnétique délivré par le codeur.

En relation avec les figures 2, on décrit ci-dessous l'intégration des éléments sensibles 1 dans un montage 4 en boucle de courant. La figure 2a représente un montage 4 comprenant N = 4 éléments sensibles 1 alignés dont les barycentres sont espacés d'une distance constante les uns des autres qui est égale à $\lambda/N$.

Dans ce cas, les résistances aux bornes de chacun des éléments sensibles 1 s'écrivent :

$$R_1 = R_0 + \Delta R.\sin (\omega t)$$

$$R_2 = R_0 + \Delta R.\sin (\omega t+\pi/2)$$

$$R_3 = R_0 + \Delta R.\sin (\omega t+\pi) = R_0 - \Delta R.\sin (\omega t)$$

$$R_4 = R_0 + \Delta R.\sin (\omega t+3\pi/2) = R_0 - \Delta R.\sin (\omega t+\pi/2)$$

Le dispositif de conditionnement 5 peut comprendre au moins un étage de comparateurs qui sont branchés aux bornes des éléments sensibles 1 pour combiner entre eux les signaux de résistance de chacun desdits éléments. En particulier, le document WO-2006/064169 décrit un dispositif de conditionnement agencé pour délivrer deux signaux respectivement SIN et COS en quadrature et de même amplitude qui sont chacun représentatif du champ magnétique, lesdits signaux pouvant être utilisés par un dispositif de calcul du système pour déterminer le paramètre de déplacement de l'organe mobile.

Le capteur comprend en outre un dispositif de traitement d'un signal W représentatif de la résistance total du montage 2, 4, ledit dispositif étant agencé pour délivrer un signal T représentatif de la température dudit montage qui est sensiblement indépendant du champ magnétique à détecter. Ainsi, avec le même montage 2, 4 d'éléments sensibles 1, il est possible de déterminer au moins un paramètre de déplacement ainsi qu'une température de fonctionnement.

Pour ce faire, le système comprend un dispositif de détermination d'une température de fonctionnement dudit système en fonction du signal T délivré par le dispositif de traitement. En particulier, cette détermination est avantageuse puisqu'elle est réalisée au plus près de l'organe mobile et avec les mêmes éléments sensibles 1 que ceux permettant de déterminer son paramètre de déplacement, simplifiant ainsi l'intégration mécanique et limitant le coût.

En outre, le même courant permet d'alimenter les deux fonctions du capteur et c'est un avantage des éléments sensibles 1 TMR de ne nécessiter qu'un faible courant électrique de polarisation pour leur fonctionnement. De plus, étant donnée la bonne sensibilité du capteur, il est possible de se passer d'amplificateur et d'avoir malgré tout une résolution de l'ordre de 1 °C.

Selon une réalisation, le dispositif de traitement comprend un circuit intégrant des moyens de mesure d'un signal W représentatif de la résistance total du montage 2, 4. Dans les modes de réalisations représentés, le circuit intègre un comparateur 6 et une source 7 de courant ou de tension qui est agencée pour pouvoir alimenter le montage

2, 4 avec une consigne constante, ledit comparateur étant alimenté avec ladite consigne provenant du montage 2, 4 pour délivrer le signal W représentatif de la température.

De façon avantageuse relativement à sa simplicité, le circuit intègre un amplificateur analogique 6 à gain et/ou à offset ajustables dont une entrée est alimentée avec la consigne provenant du montage 2, 4.

Dans le mode de réalisation des figures 1, si le montage 2 en pont de Wheatstone est alimenté avec une consigne de courant constante $i_s$, nous avons :

$$V_S = \cfrac{1}{\cfrac{1}{R_1 + R_2} + \cfrac{1}{R_3 + R_4}} . i_s$$

$$= \cfrac{1}{\cfrac{1}{R_0 + \Delta R.\sin(\omega t) + R_0 + \Delta R.\sin(\omega t + \pi)} + \cfrac{1}{R_0 + R_0}} . i_s$$

$$= \cfrac{1}{\cfrac{1}{R_0 + R_0} + \cfrac{1}{R_0 + R_0}} . i_s$$

$$= R_0 . i_s$$

$V_s$ ne dépend donc pas du champ magnétique mais uniquement de $R_0$ qui dépend de la température avec une linéarité suffisante pour pouvoir déterminer la température. De même, en alimentant le pont avec une tension constante et en mesurant le courant $i_s$ traversant ledit pont, on obtient une mesure qui est proportionnelle à la température.

Dans le mode de réalisation des figures 2, si le montage 4 en boucle de courant est alimenté avec un courant $i_s$ constant, nous avons :

$$V_s = V_1 + V_2 + V_3 + V_4$$

$$= (R_1 + R_2 + R_3 + R_4) . i_s$$

$$= (R_0 + \Delta R.\sin(\omega t) + R_0 + \Delta R.\sin(\omega t + \pi/2) + R_0 - \Delta R.\sin(\omega t) + R_0 - \Delta R.\sin(\omega t + \pi/2)) . i_s$$

$$= 4 . R_0 . i_s$$

Là encore, $V_s$ ne dépend pas du champ magnétique mais uniquement de la résistance $R_0$ qui dépend de la température. De même, en alimentant la boucle avec une tension constante et en mesurant le courant $i_s$ traversant ladite boucle, on obtient une mesure qui est également proportionnelle à la température.

Par conséquent, grâce aux propriétés des motifs à base d'un matériau magnétorésistif à effet tunnel, on peut mesurer à la fois les variations de résistance qui sont représentatives du champ magnétique et les variations de résistance qui sont dépendantes de la température. En particulier, le champ magnétique est détecté de façon différentielle, la température étant déterminée en fonction de la résistance totale du montage 2, 4 d'éléments sensibles 1.

Selon une réalisation, le dispositif de traitement comprend des moyens de filtrage temporel du signal W représentatif de la résistance totale du montage 2, 4 afin de ne pas mesurer l'offset magnétique du codeur. En particulier, cette réalisation est envisageable puisque les deux phénomènes n'ont pas les mêmes caractéristiques (périodicité, constante de temps).

L'invention permet notamment de déterminer la température avec une sensibilité de l'ordre de -0,1%/°C, soit seulement 4 fois mois qu'une sonde platine PT100 classique mais environ 20 fois plus qu'un thermocouple. En outre, la sensibilité à la température des matériaux TMR est sensiblement constante sur une grande plage de température, ce qui permet de se passer de moyen de linéarisation du signal T représentatif de la température.

**Revendications**

1. Système de détermination d'au moins un paramètre de déplacement d'un organe mobile par rapport à une structure fixe, ledit système comprenant :

   - un codeur destiné à être solidaire de l'organe mobile de sorte à se déplacer conjointement avec lui, ledit codeur étant agencé pour émettre un champ magnétique périodique qui est représentatif du déplacement du codeur ;
   - un capteur de détection d'un champ magnétique périodique comprenant plusieurs éléments sensibles (1) qui sont intégrés dans un montage (2, 4), ledit capteur étant destiné à être solidaire de la structure fixe avec les éléments sensibles (1) à distance de détection du champ magnétique périodique émis par le codeur, chaque élément sensible (1) comprenant au moins un motif à base d'un matériau magnétorésistif à effet tunnel dont la résistance varie en fonction dudit champ magnétique, ledit capteur comprenant un dispositif de conditionnement (3, 5) de signaux représentatifs de la résistance des éléments sensibles (1) qui est agencé pour délivrer au moins un signal (S) représentatif dudit champ magnétique, ledit capteur comprenant en outre un dispositif de traitement d'un signal (W) représentatif de la résistance totale du montage (2, 4), ledit dispositif étant agencé pour délivrer un signal (T) représentatif de la température dudit montage qui est sensiblement indépendant du champ magnétique à détecter ;
   - un dispositif de calcul pour déterminer le paramètre de déplacement de l'organe mobile en fonction du signal (S) délivré par le dispositif de conditionnement (3, 5) ;
   - **caractérisé par** un dispositif de détermination d'une température de fonctionnement dudit système en fonction du signal (T) délivré par le dispositif de traitement.

2. Système de détermination selon la revendication 1, **caractérisé en ce que** le dispositif de traitement comprend un circuit intégrant des moyens de mesure d'un signal représentatif de la résistance totale du montage (2, 4).

3. Système de détermination selon la revendication 2, **caractérisé en ce que** le circuit intègre un comparateur (6) et une source (7) de courant ou de tension qui est agencée pour pouvoir alimenter le montage (2, 4) avec une consigne constante, ledit comparateur étant alimenté avec ladite consigne provenant du montage pour délivrer le signal (T) représentatif de la température.

4. Système de détermination selon la revendication 3, **caractérisé en ce que** le comparateur (6) est un amplificateur analogique à gain et/ou à offset ajustables dont une entrée est alimentée avec la consigne (W) provenant du montage (2, 4).

5. Système de détermination selon l'une quelconque des revendications 1 à 4, **caractérisé en ce que** les éléments sensibles (1) comprennent un groupe de motifs reliés en série.

6. Système de détermination selon l'une quelconque des revendications 1 à 5, **caractérisé en ce que** le dispositif de conditionnement (3, 5) comprend des moyens de mesure de signaux qui sont chacun représentatifs de la résistance d'un élément sensible, ainsi que des moyens de combinaison desdits signaux pour délivrer au moins un signal (S) représentatif du champ magnétique.

7. Système de détermination selon l'une quelconque des revendications 1 à 6, **caractérisé en ce que** les éléments sensibles (1) sont intégrés dans un montage (2) en pont de Wheatstone, le dispositif de conditionnement comprenant un comparateur (3) des sorties ($V_{out1}$, $V_{out2}$) dudit pont.

8. Système de détermination selon la revendication 7, **caractérisé en ce que** le codeur délivre un champ magnétique de période spatiale $\lambda$, au moins deux éléments sensibles (1) étant intégrés dans respectivement une branche du pont de Wheatstone avec leurs barycentres espacés d'une distance $\lambda/2$.

9. Système de détermination selon l'une quelconque des revendications 1 à 6, **caractérisé en ce que** les éléments sensibles (1) sont intégrés dans un montage (4) en boucle de courant, le dispositif de conditionnement (5) comprenant au moins un étage de comparateurs qui sont branchés aux bornes des éléments sensibles (1).

10. Système de détermination selon la revendication 9, **caractérisé en ce que** le montage (4) comprend N éléments sensibles (1) alignés dont les barycentres sont espacés d'une distance constante les uns des autres.

11. Système de détermination selon la revendication 10, **caractérisé en ce que** le codeur délivre un champ magnétique de période spatiale λ, les barycentres des N éléments sensibles (1) étant espacés d'une distance λ/N les uns des autres.

12. Système de détermination selon l'une quelconque des revendications 1 à 11, **caractérisé en ce que** le dispositif de conditionnement (3, 5) est agencé pour délivrer deux signaux (S) respectivement SIN et COS en quadrature et de même amplitude qui sont chacun représentatifs du champ magnétique.

13. Système de détermination selon l'une quelconque des revendications 1 à 12, **caractérisé en ce que** le codeur comprend une succession alternée de pôles magnétiques Nord et Sud.

**Patentansprüche**

1. System zum Bestimmen zumindest eines Bewegungsparameters eines beweglichen Elements im Verhältnis zu einer festen Struktur, wobei das besagte System folgendes umfasst:

- einen Geber, der dazu bestimmt ist, fest mit dem beweglichen Element verbunden zu sein, um sich gemeinsam mit ihm zu bewegen, wobei der besagte Geber angeordnet ist, um ein periodisches Magnetfeld auszugeben, das repräsentativ für die Bewegung des Gebers ist;
- einen Sensor zum Erfassen eines periodischen Magnetfelds, mehrere empfindliche Elemente (1) umfassend, die in einer Montage (2, 4) enthalten sind, wobei der besagte Sensor dazu bestimmt ist, fest mit der festen Struktur mit den empfindliche Elementen (1) auf Erkennungsabstand des periodischen Magnetfelds verbunden zu sein, das vom Geber ausgegeben wird, wobei jedes empfindliche Element (1) zumindest ein Motiv auf Basis eines magnetoresistiven Materials mit Tunneleffekt umfasst, dessen Widerstand in Abhängigkeit vom besagten Magnetfeld variiert, wobei der besagte Sensor eine Konditioniervorrichtung (3, 5) von repräsentativen Signalen für den Widerstand der empfindlichen Elemente (1) umfasst, die angeordnet ist, um zumindest ein repräsentatives Signal (S) für das besagte Magnetfeld abzugeben, wobei der besagte Sensor darüber hinaus eine Vorrichtung zum Bearbeiten eines Signals (W) umfasst, das repräsentativ für den Gesamtwiderstand der Montage (2, 4) ist, wobei die besagte Vorrichtung angeordnet ist, um ein Signal (T) auszugeben, das repräsentativ für die Temperatur der besagten Montage ist, das etwa unabhängig vom Magnetfeld ist, das es zu erfassen gilt;
- eine Berechnungsvorrichtung zum Bestimmen des Bewegungsparameters des beweglichen Elements in Abhängigkeit vom Signal (S), das von der Konditioniervorrichtung (3, 5) ausgegeben wird;
- **gekennzeichnet durch** eine Vorrichtung zum Bestimmen einer Betriebstemperatur des besagten Systems in Abhängigkeit vom Signal (T), das von der Vorrichtung zum Bearbeiten ausgesandt wird.

2. Bestimmungssystem nach Anspruch 1, **dadurch gekennzeichnet, dass** die Vorrichtung zum Bearbeiten einen Kreis umfasst, in dem Mittel zum Messen eines repräsentativen Signals für den Gesamtwiderstand der Montage (2, 4) enthalten sind.

3. Bestimmungssystem nach Anspruch 2, **dadurch gekennzeichnet, dass** der Kreis einen Vergleicher (6) und eine Strom- oder Spannungsquelle (7) umfasst, die angeordnet ist, um die Montage (2, 4) mit einem konstanten Sollwert versorgen zu können, wobei der besagte Vergleicher mit dem besagten Sollwert aus der Montage versorgt wird, um das repräsentative Signal (T) für die Temperatur auszugeben.

4. Bestimmungssystem nach Anspruch 3, **dadurch gekennzeichnet, dass** der Vergleicher (6) ein analoger Verstärker mit einstellbarer Verstärkung und/ oder einstellbarem Offset ist, von dem ein Eingang mit dem Sollwert (W) aus der Montage (2, 4) versorgt wird.

5. Bestimmungssystem nach irgendeinem der Ansprüche 1 bis 4, **dadurch gekennzeichnet, dass** die empfindlichen Elemente (1) eine Gruppe von Motiven umfassen, die in Reihe geschaltet sind.

6. Bestimmungssystem nach irgendeinem der Ansprüche 1 bis 5, **dadurch gekennzeichnet, dass** die Konditioniervorrichtung (3, 5) Mittel zum Messen von Signalen umfasst, die jeweils repräsentativ für den Widerstand eines empfindlichen Elements sind, sowie Mittel zum Kombinieren der besagten Signale zum Ausgeben zumindest eines repräsentativen Signals (S) für das Magnetfeld.

7. Bestimmungssystem nach irgendeinem der Ansprüche 1 bis 6, **dadurch gekennzeichnet, dass** die empfindlichen Elemente (1) in eine Wheatstone-Brücken-Montage (2) integriert sind, wobei die Konditioniervorrichtung einen Ver-

gleicher (3) der Ausgänge ($V_{out1}$, $V_{out2}$) der besagten Brücke umfasst.

8. Bestimmungssystem nach Anspruch 7, **dadurch gekennzeichnet, dass** der Geber ein Magnetfeld mit räumlicher Periode $\lambda$ ausgibt, wobei zumindest zwei empfindliche Elemente (1) in jeweils einem Schenkel der Wheatstone-Brücke mit ihren Baryzentren in einem Abstand von $\lambda/2$ integriert sind.

9. Bestimmungssystem nach irgendeinem der Ansprüche 1 bis 6, **dadurch gekennzeichnet, dass** die empfindlichen Elemente (1) in einer Montage (4) in einer Stromschleife integriert sind, wobei die Konditioniervorrichtung (5) zumindest eine Stufe von Vergleichern umfasst, die an den Klemmen der empfindlichen Elemente (1) angeschlossen sind.

10. Bestimmungssystem nach Anspruch 9, **dadurch gekennzeichnet, dass** die Montage (4) N aneinandergereihte empfindliche Elemente (1) umfasst, deren Baryzentren in einem konstanten Abstand zueinander angeordnet sind.

11. Bestimmungssystem nach Anspruch 10, **dadurch gekennzeichnet, dass** der Geber ein Magnetfeld mit räumlicher Periode $\lambda$ ausgibt, wobei die Baryzentren der N empfindlichen Elemente (1) in einem Abstand von A/N zueinander angeordnet sind.

12. Bestimmungssystem nach irgendeinem der Ansprüche 1 bis 11, **dadurch gekennzeichnet, dass** die Konditioniervorrichtung (3, 5) angeordnet ist, um zwei Signale (S), jeweils SIN und COS in Quadratur und mit derselben Amplitude auszugeben, die jeweils repräsentativ für das Magnetfeld sind.

13. Bestimmungssystem nach irgendeinem der Ansprüche 1 bis 12, **dadurch gekennzeichnet, dass** der Geber eine abwechselnde Folge von magnetischen Polen Nord und Süd umfasst.

**Claims**

1. System for determining at least one parameter for the movement of a member able to move with respect to a fixed structure, said system comprising:

   - an encoder intended to be secured to the movable member so as to move conjointly with it, said encoder being arranged so as to emit a periodic magnetic field that represents the movement of the encoder;
   - a sensor for detecting a periodic magnetic field, comprising several sensitive elements (1) that are integrated in an assembly (2, 4), said sensor being intended to be secured to the fixed structure with the sensitive elements (1) at a distance for detecting the periodic magnetic field emitted by the encoder, each sensitive element (1) comprising at least one pattern based on a tunnel-effect magnetoresistive material, the resistance of which varies according to said magnetic field, said sensor comprising a device (3, 5) for conditioning signals representing the resistance of the sensitive elements (1) that is arranged so as to deliver at least one signal (S) representing said magnetic field, said sensor further comprising a device for processing a signal (W) representing the total resistance of the assembly (2, 4), said device being arranged so as to deliver a signal (T) representing the temperature of said assembly, which is substantially independent of the magnetic field to be detected;
   - a computing device for determining the movement parameter of the movable member according to the signal (S) delivered by the conditioning device (3, 5);
   - **characterised by** a device for determining an operating temperature of said system according to the signal (T) delivered by the processing device.

2. Determination system according to claim 1, **characterised in that** the processing device comprises a circuit integrating means for measuring a signal representing the total resistance of the assembly (2, 4).

3. Determination system according to claim 2, **characterised in that** the circuit integrates a comparator (6) and a current or voltage source (7) that is arranged so as to be able to supply the assembly (2, 4) with a constant set value, said comparator being supplied with said set value coming from the assembly in order to deliver the signal (T) representing the temperature.

4. Determination system according to claim 3, **characterised in that** the comparator (6) is an analogue amplifier with adjustable gain and/or offset, an input of which is supplied with the set value (W) coming from the assembly (2, 4).

5. Determination system according to any one of claims 1 to 4, **characterised in that** the sensitive elements (1) comprise a group of patterns connected in series.

6. Determination system according to any one of claims 1 to 5, **characterised in that** the conditioning device (3, 5) comprises means for measuring signals that each represent the resistance of a sensitive element, as well as means for combining said signals in order to deliver at least one signal (S) representing the magnetic field.

7. Determination system according to any one of claims 1 to 6, **characterised in that** the sensitive elements (1) are integrated in a Wheatstone bridge assembly (2), the conditioning device comprising a comparator (3) for the outputs ($V_{out1}$, $V_{out2}$) of said bridge.

8. Determination system according to claim 7, **characterised in that** the encoder delivers a magnetic field of spatial period $\lambda$, at least two sensitive elements (1) being integrated in respectively an arm of the Wheatstone bridge with their barycentres spaced apart by a distance $\lambda/2$.

9. Determination system according to any one of claims 1 to 6, **characterised in that** the sensitive elements (1) are integrated in a current-loop assembly (4), the conditioning device (5) comprising at least one stage of comparators that are connected to the terminals of the sensitive elements (1).

10. Determination system according to claim 9, **characterised in that** the assembly (4) comprises N aligned sensitive elements (1), the barycentres of which are spaced apart by a constant distance from one another.

11. Determination system according to claim 10, **characterised in that** the encoder delivers a magnetic field of spatial period $\lambda$, the barycentres of the N sensitive elements (1) being spaced apart by a distance $\lambda/N$ from one another.

12. Determination system according to any one of claims 1 to 11, **characterised in that** the conditioning device (3, 5) is arranged to deliver two signals (S), respectively SIN and COS, in quadrature and with the same amplitude, which each represent the magnetic field.

13. Determination system according to any one of claims 1 to 12, **characterised in that** the encoder comprises an alternating succession of North and South magnetic poles.

## Fig. 1

## Fig. 1a

## Fig. 2

## Fig. 2a

**EP 2 784 529 B1**